(19) Europäisches Patentamt
European Patent Office
Office européen des brevets

(11) **EP 0 429 306 B1**

(12) **EUROPEAN PATENT SPECIFICATION**

(45) Date of publication and mention
of the grant of the patent:
**18.09.1996 Bulletin 1996/38**

(51) Int Cl.6: **H03M 7/40**, H03M 7/42

(21) Application number: **90312698.5**

(22) Date of filing: **21.11.1990**

(54) **Data compaction system**

Datenkomprimierungssystem

Système de compression de données

(84) Designated Contracting States:
**DE FR GB**

(30) Priority: **22.11.1989 US 441681**

(43) Date of publication of application:
**29.05.1991 Bulletin 1991/22**

(73) Proprietor: **International Business Machines
Corporation
Armonk, N.Y. 10504 (US)**

(72) Inventors:
 • **MacLean, Neil Hector, Jr.
 Tucson, AZ 85715 (US)**
 • **Patel, Mayank Raman
 Tucson, AZ 85710 (US)**

 • **Ripberger, Richard Anthony
 Tucson, AZ 85712 (US)**

(74) Representative: **Burt, Roger James, Dr.
 IBM United Kingdom Limited
 Intellectual Property Department
 Hursley Park
 Winchester Hampshire SO21 2JN (GB)**

(56) References cited:
 • **PATENT ABSTRACTS OF JAPAN vol. 13, no. 518
 (E-848)(3866) 20 November 1989 & JP-A-1 209
 819 (NIPPON TELEGRAPH & TELEPHONE
 CORP.) 23 August 1989**
 • **PATENT ABSTRACTS OF JAPAN vol. 12, no. 489
 (E-696)(3336) 21 December 1988 & JP-A-63 204
 922 (FUJITSU LTD) 24 August 1988**

## Description

The present invention relates to a data compaction system.

It is often necessary to have a plurality of data compaction processors in a data compaction system operating in parallel to sustain a required throughput data rate. Each encoder and decoder of each compaction processor must process the data directed to it in a known maximum period of time. Since the compaction is done by a plurality of the parallel units, the slowest unit can limit the throughput data rate.

The object of the present invention is to provide an improved data compaction system.

This object is achieved by the invention claimed in claim 1.

In known arrangements each compaction unit processes a plurality of sets of the data, and the modifier information obtained from each encoder must be retained across the sets of data. The order of the sets of data must also be kept the same throughout the process. The modifier data is obtained from the statistical tables of the arithmetic coding system. Also, for decoding, the modifier information obtained from each decoder must be retained across the sets of data.

The standard method is to solve the modifier retention problem by including one statistics table in one compaction unit so that a specific format is achieved for a given data rate. The throughput data rate is then determined by the number of compression units that are placed in parallel. The larger the number of compression units, the higher the data rate can be since each unit can process a portion of the data. So the throughput required determines the number of parallel compaction units. The number of compaction units determines the format of the compressed data, since the learning curve of the statistic table with each encoder is used to process, i.e., compress, later data. More compaction units formerly added statistic tables and therefore changed the format. Earlier encoded data could no longer be reliably decoded. If a higher data rate is required at a later time, then a new format using more of the compaction units is established. The new format, that the higher number of parallel connected compaction units provides, prevents the decoding of the data that was encoded under the previous format and vice versa. Thus before this invention, the increase in the data rate precluded upward and downward compatibility between the previous system and the improved system.

DESCRIPTION OF TNE RELATED ART

The following references show different aspects of the Binary Arithmetic Coding process. The invention of this Application uses a modification of the process.

Arithmetic Coding, G. G. Langdon, Jr., et al. IBM Journal Research and Development, Volume 23, Number 2, March, 1979, Page 149-162.

Method for Carry-Over Control in a FIFO Arithmetic Code String, IBM Technical Disclosure Bulletin, Volume 23, Number 1, June, 1980, Pages 310-312.

Deblocking Method for Use with an Adaptive Arithmetic Encoder/Decoder, IBM Technical Disclosure Bulletin, Volume 23, Number 6, November, 1980, Pages 2528-2529.

Universal Modelling and Coding, J. J. Rissanen, IEEE Transactions on Information Theory, Volume IT-27, Number 1, January, 1981, Pages 12-23.

Statistics Collection for Compression Coding with Randomising Feature, IBM Technical Disclosure Bulletin, Volume 24, Number 10, March, 1982, Page 4917.

A Simple General Binary Source Code, G. G. Langdon, Jr., et al., IEEE Transactions on Information Theory, Volume IT-28, Number 5, September, 1982, Pages 800-803.

Control Character Insertion into Arithmetically Encoded Strings, IBM Technical Disclosure Bulletin, Volume 25, Number 4, September, 1982, Pages 2051-2052.

A Double-Adaptive File Compression Algorithm, G. G. Langdon, Jr., et al., IEEE Transactions on Communications, Volume COM-31, Number 11, November, 1983, Pages 1253-5.

An Introduction to Arithmetic Coding, G. G. Langdon, Jr., IBM Journal Research Development, Volume 28, Number 2, March, 1984, Pages 135-149.

Overlapped Statistics Memory Access for Decompression, IBM Technical Disclosure Bulletin, Volume 27, Number 1B, June, 1984, Pages 871-872.

United States Patent 4,467,317, High Speed Arithmetic Compression Coding Using Concurrent Value Updating, G. G. Langdon, Jr., et al.

None of the above references disclose the invention of this Application of format compatibility of compaction processes between systems having different throughput rates.

According to a preferred embodiment of the invention the compaction system first partitions the data stream into equal size manageable entities or sets of data. These sets of data are each distributed in turn through a demultiplexer to a plurality of encoders for compression. Each encoder includes a plurality of statistics tables to allow format compatibility with the increased throughput of the binary arithmetic encoders by adding units while reducing the required hardware and providing the expansion to the higher throughput configuration. The compacted sets of data are resequenced in a multiplexer.

To decode the data, the compacted sets are directed to a demultiplexer to distribute each compacted set of data to one of a plurality of decoders. Each decoder also includes a plurality of statistic tables to allow format compatibility with the increased throughput of the plurality of decoders while similarly reducing the required hardware and providing expansion to a higher throughput configuration while providing downward compatibility to the lower throughput configuration. The decompacted sets of data are resequenced through a multiplexer to reassemble the decompacted sets into their original form.

Thus, according to the preferred embodiment, a plurality of compaction processors can be used to sustain a desired data rate while still maintaining format compatibility. Data is first divided into equal sized sets of data for parallel processing by each compaction processor. Each compaction processor (CP) contains a number m of statistic tables (ST) for a number n of compaction processors. The number of sets of data is equal to q and i is the set number, i.e., o, 1, 2 ....q-1. Set i is processed by compaction processor STP j, using the statistic table ST j k where:

$$j = i \text{ Modulo } n$$

$$k = (i \text{ divided by } n) \text{ Modulo } m$$

For an N CP system with M STs in each CP, the possible configuration of a lesser number than N processors is defined by:

$$m \leq M$$

$$n \leq N$$

where M, N, m, and n are all integers greater than zero. n is the number of CPs used out of the maximum N in a CP system, and m is the number of STs used out of the maximum M in each CP.

The preferred embodiment of the invention therefore provides an enhanced compaction system that permits upward and downward format compatibility of the encoding and decoding process.

The preferred embodiment partitions the records into manageable entities or sets and processes the data through a compaction system that can be expanded or contracted to process the data stream at a desired maximum variable data rate. The number of encoders and decoders used in the successive transfer of data is dependent on the rate of the data transferred with each successive encoder and decoder handling the compaction and decompaction, respectively, in parallel. The number of encoders and decoders used can expand and contract, depending upon the maximum data rate required. By choosing the appropriate number of encoders and decoders, and how many statistic tables in each, the data format compatibility is maintained.

The preferred embodiment therefore also provides a compaction system that can be adapted to the throughput rate inherent in the data to compress and process the data at the higher rate required by present day record processing systems while providing upward and downward format compatibility that will be able to decode media encoded at both the increased throughput rate and the standard throughput rate.

Adaptive compression is performed in one of two mutually exclusive modes: the run mode which filters out runs of the same character whenever two or more of the same bytes are encountered and the byte mode which serialises data bytes and codes each byte according to its own statistics. Results of both modes are used to collect statistics in a statistic table. The statistics are gathered to establish patterns of bits within the bytes and are stored as the probability of predicting the next bit based on the previous experience. The adaptive compression process maps a string of data bits, using the adaptive data statistics, to a code string in such a way that the original data can be recovered from the code string. The amount of compression is directly proportional to the number of correct bit predictions.

The preferred embodiment still further provides a compression system that utilises a plurality of parallel compaction processors and that is adaptable to the data stream while providing a predictable throughput rate together with format compatibility to a compaction system having an increased throughput rate by the addition of parallel compaction units.

Another application of the preferred embodiment is for a Lempel-Ziv process that converts variable-length strings of input symbols into fixed-length codes. This process is an adaptive compression process that starts with an empty table of symbol strings, i.e., a dictionary, and builds the table during both the compression and decompression processes. A plurality of encoders and decoders may be used to increase the throughput of such a system. For a more complete description of the Lempel-Ziv process, reference is made to the articles "A Universal Algorithm for Sequential Data Compression", J. Ziv, et al., IEEE Transactions on Information Theory, Vol. IT-3, May 1977, pages 337-343; and "Compression of Individual Sequences via Variable-Rate Coding", J. Ziv, et al., IEEE Transactions on Information Theory, Vol. IT-24, No. 5, September 1978, page 5306.

In order that the invention may be more readily understood an embodiment will now be described with reference to the accompanying drawings in which:-

Figure 1 is a generalised block diagram of a data compaction system with a plurality of parallel connected compaction processors,

Figure 2 is a diagrammatic representation of the interconnection of two compaction processors of Figure 1,

Figure 3 is a more detailed block diagram of one compaction processor shown in Figure 1,

Figures 4 to 8 show flow charts of different procedures performed by the encoder of Figure 3,

Figure 9 shows the flow of the encoding process that generates a sum of the probabilities as an output of the encoder shown in Figure 3,

Figure 10 shows a flow chart of the probability calculation based on the statistics tables of Figure 3, and

Figures 11 to 15 show the flow of the processing for the decoder of Figure 3.

The arrangement to be described is preferably for use with a magnetic tape system and in particular is for use in the IBM 3490 tape drive. The preferred embodiment described herein will, therefore, be for a magnetic tape system, but it should be understood that the arrangement described could be adapted for use in any storage, communication, or transmission system or could be used in any portion of a data processing system where a stream of data is to be compacted for storage, for instance, and then retrieved and decompacted for utilisation by the data processing system.

The arrangement described covers an efficient method of compacting most types of data into sufficiently smaller data blocks. The procedure as described can be added to the current hardware of an IBM 3480 tape drive. Thereby, the system provides the advancements gained with this invention while continuing to interchange data with the users of the host data processing system when necessary.

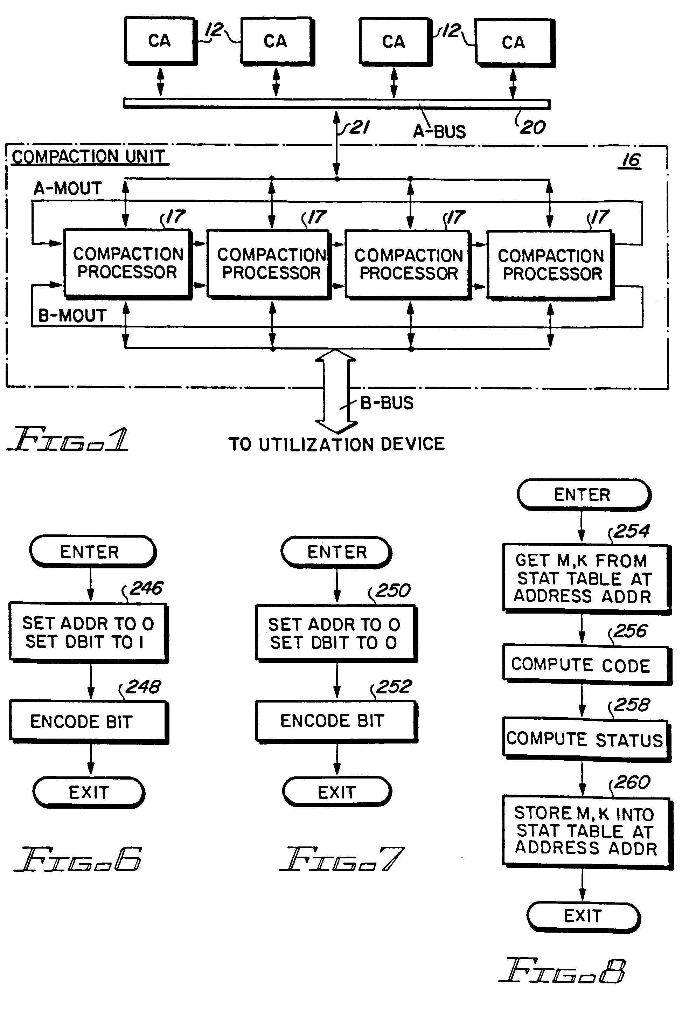

Referring more particularly to the drawings, the same reference numerals indicate like structural features and operation in the various Figures of the drawings. A compaction system as shown by a plurality of parallel operating compaction processors 1-4 of Figure 1, compacts data during a Channel Write operation and decompacts data during a Channel Read operation, when an extended format is selected. Data compaction is performed by using a modified version of the binary arithmetic compaction (BAC) program, explained in the article: <u>An Introduction to Arithmetic Coding</u>, by Glenn G. Langdon, Jr., IBM Journal of Research and Development, Volume 28, Number 2, March 1984.

Data is encoded by each compaction processor at the rate of 1.25 megabytes per second. Each compaction processor added in parallel permits an additional 1.25 megabytes per second encoding rate, thus increasing the data processing rate. Each additional compaction processor affects the statistics format of the entire compaction system. By this arrangement, a method will be shown whereby the throughput of the compaction process can be increased by adding compaction processors while the present design accommodates that increase. The increase in the number of compaction processors, while retaining format compatibility with the present embodiment for instance, can be accommodated through the addition of statistical tables to the present embodiment, as will be described later in more detail.

As shown in Figure 1, a plurality of channel adaptors (CA) 12 are connected to a utilisation device such as a tape recording medium through a plurality of compaction processors 17 located in a compaction unit 16. The compaction processors 17 each receive the unformatted data from the channel adapters 12 through an A-bus 20. This will be discussed in more detail later. Each compaction processor 17 receives the unformatted data from the channel adaptors 12 via the A-bus 20. The stream of data is directed to the compaction processors 17 where they are separated into identical size blocks or sets of data. The individual sets of data are then directed to individual encoders in each compaction processor 17 for compression of each set in turn by the different encoders. The compacted sets of data are then reassembled and formatted for writing onto a tape medium, i.e., the utilisation device shown in Figure 1.

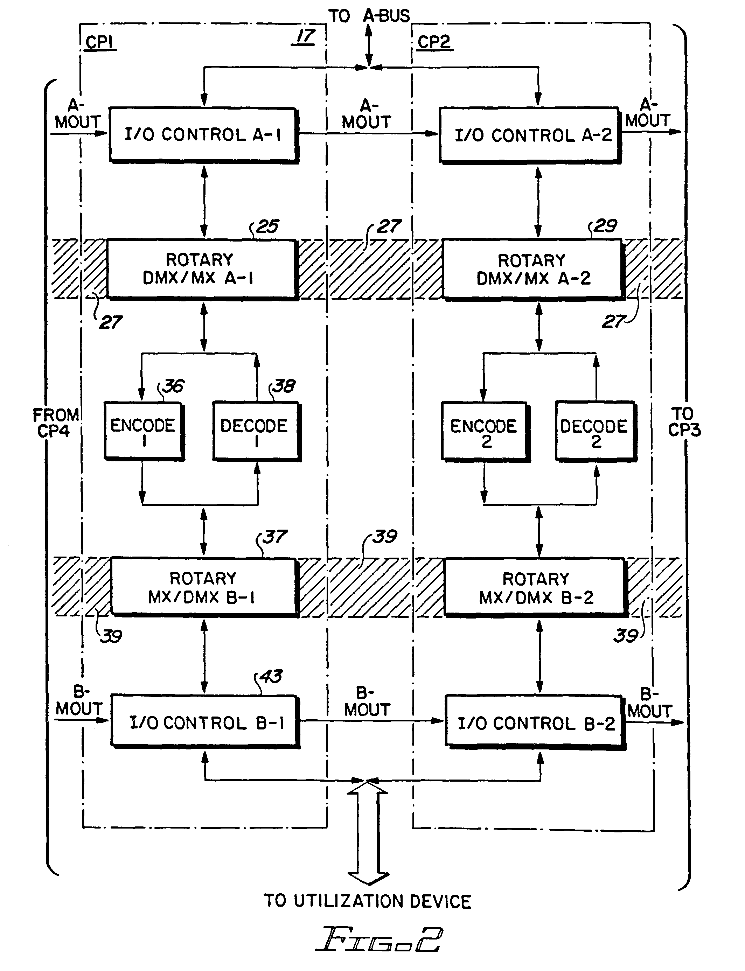

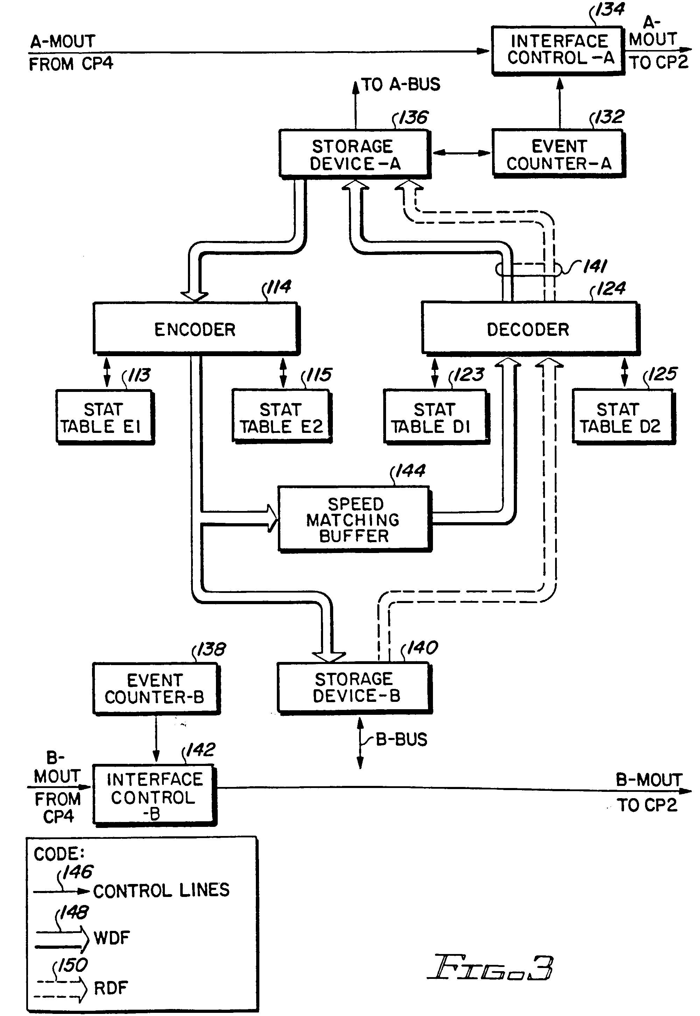

Referring now especially to Figure 1, the plurality of compaction processors 17 is inserted into a standard read and write data flow that interconnects a plurality of channel adapters 12 to interface with the utilisation device, for this instance, the read and write format control to and from a recording tape medium. The stream of data from a host processing unit is directed to one of the plurality of channel adaptors 12 to interface with the parallel operating compaction processing devices 17. A channel adapter command set, Extended Format, directs the data stream transfer through the CA12 interfaces to the A-bus 20 and along a line 21, to the plurality of compaction processors 17. The data stream from the A-bus 20 as directed to all of the compaction processors 17, and it is an A-mout signal that controls the receipt and distribution of the data to and from the compaction processors. The procedure will be discussed in more detail for Figures 2 and 3.

The compaction processors 17, receive the unformatted data from the active CA 12. The compaction processors 17 as a tandem unit shown as a compaction unit 16, separate the unformatted data into identical size blocks or sets of data from the data stream. The individual sets of data are then directed to individual ones of the compaction processors 17 for compaction encoding of each set in turn. The processed sets of data are then reassembled into their original sequence and transmitted to a B-bus for formatting before writing onto the tape medium, the utilisation device. The more diagrammatic flow diagram of two processing devices and the interconnection of each is shown in Figure 2.

Referring to Figure 2, the data stream is directed from the A-bus 20 into an input/output control unit one for each of the compaction processors. Compaction processors CP1 and CP2 only are shown on Figure 2. The data stream in Figure 2 is directed to I/O control unit A-1 for CP1 and I/O control unit A-2 for CP2. The I/O control unit A-1 determines the set of data that is to be directed to CP 1. The A-mout signal determines which I/O control unit is active at any particular period of time. Each processing device, CP 1 for instance, also includes a section of a rotary demultiplexer/multiplexer device 25, shown as DMX/MXA-1. Sets of dashed and cross-hatching lines 27, connecting the rotary demultiplexer/multiplexer 25, and a rotary demultiplexer/multiplexer 29 of processing device CP2 indicates that all of the rotary demultiplexers/multiplexers 25, 29 etc are interconnected in order to form one rotary demultiplexer and multiplexer unit that effectively controls the transfer of one set of data into each of the compaction processors 17.

CP1 also includes an encode unit 36 and a decode unit 38. The output from the encode unit 36 is supplied to and the input to the decode unit 38 is received from another rotary multiplexer/demultiplexer 37, shown as MX/DMXB-1, that is the resequencing hardware for the encode unit 36, and the separation hardware for the decode unit 38. The interconnection of all of the rotary MX/ DMX units, such as rotary multiplexer/demultiplexer 37 for CP 1, operates to perform its multiplexer/demultiplexer function, as shown by the dashed and cross-hatched lines 39. The compaction processors 17, operating in parallel as shown in Figure 1, therefore include an input/output control and a rotary demultiplexer and multiplexer 25, 29 for the upper or A section of each of the compaction processors 17 and an input /output control and a rotary multiplexer and demultiplexer 37 etc for the lower or B section of each of the compaction processors 17.

The data stream from the A-bus 20 is directed to the I/O control unit of each of the compaction processors 17. The A-mout signal directs which compaction processor is to get its set of data out of the data stream. Each rotary demultiplexer and multiplexer distributes the set of data to the encode and decode units within its associated compaction processor. At initialisation for instance, CP 1 gets the first set of data, 512 bytes for the preferred embodiment, and then the A-mout signal is activated and CP 2 takes the second set. CP 3 gets the next set and then CP 4 gets its set of data. The next set of data is then transferred to CP 1 to continue the sequence. For the actual hardware included into one compaction processor of Figures 1 and 2, reference is made to Figure 3.

As shown in Figure 3, each compaction processor 17, and in particular CPI, includes an event counter -A 132, an interface control unit -A 134, and a storage device -A 136. These devices are unique to the upper or A section of CP1. The lower or B section of the CP1 also includes an event counter -B 138, a storage device -B 140, and an interface control unit -B 142. Each compaction processor also includes one encoder 114, one decoder 124, and a speed matching buffer 144. The event counters such as 132 and 138 are used in the upper and lower sections respectively of each of the compaction processors to control and verify the splitting and merging of the respective data sets into and out of the compaction processor. The encoder 114 includes two statistics tables 113 and 115. The decoder 124 also includes two statistics tables 123 and 125.

Continuing with Figure 3, it will be assumed that CP1 is activated which could be either through the system initialisation process or through the transfer of data flow control from the previous compacting processor, i. e., CP4. As stated previously, the signal A-mout transfers the control of data flow from one compaction processor to the next. During the Write Data operation, which is when the data stream from the host is compacted and written into the utilisation device which may be for example a magnetic tape storage device, the stream of data is directed to all storage devices in the upper or A section of the compaction processor. The storage device -A 136 signals the event counter -A 132 that one set of data has been received, i.e., 512 bytes. The event counter -A 132, in turn, signals the interface control unit -A 134, that CP1 has received its section of data, i.e., one set, and the next set of data should be received by CP2. During the Write Data operation, the set of data is transmitted using the solid line shown in Figure 3. The codes for the different lines are shown in the lowest portion of Figure 3 and are a solid single line 146 that signifies the control lines controlling the different hardware of the compaction processors, a solid double line 148 that signifies the write data flow (WDF) and a dashed double line code that signifies the read data flow (RDF) signal flow through CP1.

The set of data received in compaction processor CP1 is transmitted from the storage device -A 136 to the encoder 114 for compaction of the set of data. The encoder 114 uses the statistic tables 113 and 115 to compact the set of data. After the data compaction process is completed, the encoder 114 transmits the compacted data set to the speed matching buffer 144. The compacted data is transmitted to the speed matching buffer 144 for storage in order to match the output of the encoder 114 with that of the decoder 124. The just-compacted data is transmitted from the speed matching buffer 144 to the decoder 124 for decompaction and checking. When the checking operation has been completed the compacted data is transferred to the storage device -3 140 where it will await the control by the event counter -B 138 and the interface control -B 142 to signal that the compressed set of data can be placed onto the B-bus for transfer to the tape medium of the utilisation device.

During the Read or Retrieve Data operation to retrieve data from the tape medium, the compacted sets of data are received from the tape medium and transmitted to the storage device -B 140. The compacted bits of data information are stored within the storage device -B 140 until the entire compacted set of data is received. At that time, a delineation signal separating the compacted sets of data activates the event counter -B 138 which in turn activates the interface control unit -B 142 to transfer data flow control on the B-mout signal line to the next compaction processor, CP2. Processor CP2 can then receive its set of data for use within its compaction process.

Following the RDF signal path, the stored compacted set of data is transferred to the decoder 124 where it is decompacted and transmitted to storage device -A 136 on line 141 for storage until the storage device signals that it has received its 512 byte set of data and a signal is given to the interface control unit -A 134 such that the storage device -A 136 can transmit the set of data onto the A-bus 20 and then to the channel adapters 12. After the decompacted data has been transferred, the event counter -A 132 signals the interface controller -A 134 to transfer control via the A-mout signal line to the next compaction processor CP2. This is done so that the next set of data can be transferred from the storage device - A of processor CP2 onto the A-bus and eventually to the channel adapter. Reference is made to the copending European Patent Application number 90312697.7, filed on 21 November 1990, for a more complete description of the control and sequencing of the compaction processors CP 1-4.

Further description of the processing of the data on a tape medium system is described in the Milligan, et al., U.S. Patent 4,435,762, assigned to the assignee of the present invention.

A single compaction processor is not fast enough to compact a data stream and maintain a given data rate for the uncompressed data. The speed increase in the arrangement being described is roughly linear with the increase in the number of data compaction processors. The data written on the medium in the utilisation device can be similarly decompacted at high speed using the same number of processors as was employed for the compaction. Each of the sets of 512 byte blocks are independently compacted in a separate compaction processor. Thus the first data set goes to compaction processor CP 1, the second set to compaction processor CP 2, and so on, until the fourth set of data is compacted by the compaction processor CP 4. The fifth set goes back to CP1.

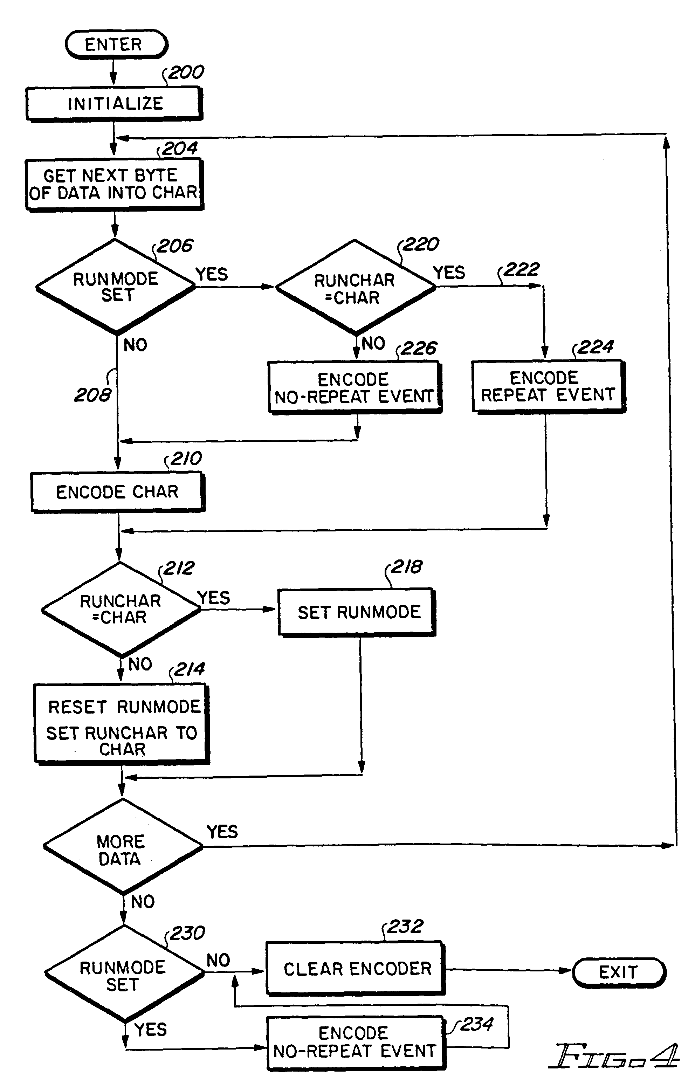

Referring to Figure 3, there is a time-critical feedback path in decoding binary information with a binary arithmetic code which involves accessing a statistic table for the next bit based on the value of the last bit. If not circumvented, this problem will slow down the cycle time required to decode each bit. In the arrangement being described a look ahead technique, reading out more than one statistic from adjacent locations, and selecting the correct statistic table, is combined with accessing different levels of a tree for each successive bit and reading out the possible statistics for two levels at the same time. The process flow chart for the encoding scheme is shown in Figure 4 and will be discussed later.

The binary arithmetic code program for the compaction of data requires binary statistics in order to achieve compaction. This entails the fetching of a statistic for each encoded or decoded bit. The statistics are stored in a linearised tree. The requirement for coding a bit is to access each level of the tree only once every eight bits encoded. Since once a statistic is used it is, then not used again for 8 bit cycles, prefetching or looking ahead to overlap the accessing of skews with the encoding or decoding of bits is employed. The statistics table E-1 113 handles the first or modulo zero data set while the statistics tables E-2 115 handles the modulo 4 packet of data out of the modulo 8 packets directed to the compaction processor.

Figure 3 shows the two statistic tables (D1. D2) 123 and 125, for the decoder 124. The statistics table 123 and statistics table 125 are shown connected to the decoder unit 124 of Figure 3 and essentially operate in the same manner as described for the statistic tables (EI, E2) 113 and 115 for the encoder 114. The random access memory of all of the statistic tables for both the encoder 114 and decoder 124 looks like eight encoders and decoders on line when four are actually in the arrangement being described. This effective doubling of the number of statistic tables for each encoder and decoder accomplishes a format compatibility with eight encoders and decoders with one statistic table in each. The eight encoders and decoders would double the throughput of the four shown in Figure 1, while the use of one statistic table for each encoder and decoder would permit format compatibility with the four encoders and decoders and two statistic tables each of the arrangement being described.

Thus, according to the arrangement being described, a plurality of compaction processors can be used to sustain a desired data rate while still maintaining format compatibility. Data is first divided into equal sized sets of data for parallel processing by each compaction processor (CP). Each compaction processor contains a number m of statistic tables (ST) for a number n of compaction processors. The number of sets of data is equal to q and i is the set number, i.e., 0, 1, 2 ....q-1. Set i is processed by compaction processor CP j, using the statistic table ST j k where:

$$j = i \text{ Modulo } n$$

$$k = (i \text{ divided by } n) \text{ Modulo } m$$

For an N CP system with M STs in each CP, the possible configuration of a lesser number than N processor is defined by:

$$m \leq M$$

$$n \leq N$$

where M, N, m, and n are all integers greater than zero. n is the number of CPs used out of the maximum N in a CP system, and m is the number of STs used out of the maximum M in each CP.

For the arrangement being described , N is equal to eight CPs and M is equal to two STs in each CP. The possible configurations are where n is equal to four and m is equal to two. An increase in throughput is possible by using eight CPs and one ST in each, i.e., n is equal to eight and m is equal to 1. Other possibilities for eight CPs, i.e., N is equal to eight, is where M is equal to eight, then the possible configurations are:

$$n = 8, m = 1$$

$$n = 4, m = 2$$

$$n = 2, m = 4$$

$$n = 1, m = 8$$

For eight CPs and where M is equal to four, then the possible configurations are:

$$n = 8, m = 1$$

$$n = 4, m = 2$$

$$n = 2, m = 4$$

Thus, format compatibility can be maintained through increases in data throughput by selection of the throughput rate required now, and the throughput rate desired later, while maintaining format compatibility through all of the throughput rate increases. Downward and upward compatibility for higher and lower throughput rate compaction is assured.

The adaptive compaction is performed for each byte in the encoder in one of two mutually exclusive modes. The first is the run mode which compresses sequential repetitions of the same character when one or more repetitions are detected. These are identified by setting the run mode sequence.

The second mode is the byte mode which codes individual bytes according to statistics which have been accumulated. The byte mode is used when the previous two bytes are different or after a byte mode indicates a non-repetition. This mode is identified when the run character equals the character. The results of both modes are used to accumulate the statistics from the statistics tables depending upon which statistic table is activated at that time. The coding program adapts to the statistics for each byte of data. For RUN mode processing, the statistic is based on the likelihood of a byte repetition. For byte mode processing, initially, each bit of each byte is assumed equally probable.

The statistics are updated on a bit basis and stored in a binary tree structure in the statistics table. The statistics are reset prior to receiving each record for the input data string. Consequently, each record is processed independently. As will be discussed with reference to Figure 4, the program dynamically determines which mode is in effect with the objective of maximising data compaction. The program maps a string of data bits, using adaptive data statistics, to a code string in such a way that the exact original data can be recovered form the code string. The amount of compaction is in direct proportion to both the number of successive byte repetitions and the preponderance of popular byte values. The encode and decode units both use the same number of statistic tables which can be selected for the maximum number of parallel operating compaction processor units required to meet the system maximum data rate. For a further discussion of the compaction processing according to Figures 4-15, reference is made to the article Arithmetic Coding by G. G. Langdon, Jr. and J. J. Rissanen, IBM Journal of Research and Development, Volume 23, Number 2, March 1979, and to the previously mentioned article An Introduction to Arithmetic Coding and to United States Patent A- 4,467,317, issued August, 1984, entitled, High Speed Arithmetic Compression Coding Using Concurrent Value Updating. These publications and the United States patent will give a much more complete description of the encoding and decoding process of the arrangement described wherein a single statistics table is used for each encoder and decoder unit.

Referring to the compaction encode process flow diagram of Figure 4, the run mode sequence is when two previous bytes are the same. The byte mode is the mode used when the run mode is not found. The run mode compresses sequential repetitions of the same character when one or more repetitions are detected. When the run mode is not found, that is when the byte mode is entered, the individual bytes are coded according to the statistics which have been accumulated and is used when the previous two bytes are different, i.e., when the run mode is not found or after a run mode indicates a non-repetition. The results of both modes are used to accumulate the statistics. The coding process adapts to the statistics for each byte. For run mode processing, the statistic is based on the likelihood of a byte repetition. For bit mode or not run mode, initially each bit of each byte is assumed equally probable. The statistics are updated on a bit basis and stored in a binary tree data structure. The statistic takes the form of a three bit field where one bit indicates which bit value is more likely, and the other two bits are a number having values having from one to four. The value gives a relative probability of the bit value that is most likely occurring, the value "one" indicating one equally likely and the value "four" most likely. The statistics are reset at the beginning of each logical block received form the host, and consequently, each logical block is processed independently. The process dynamically determines which mode is in effect with the objective of maximising data compaction. The process maps a string of data bits, using the adaptive data statistics, to a code string in such a way that the exact original data can be recovered from the code string. The amount of compaction is directly proportional to the number of successive byte repetitions and the preponderance of popular byte values.

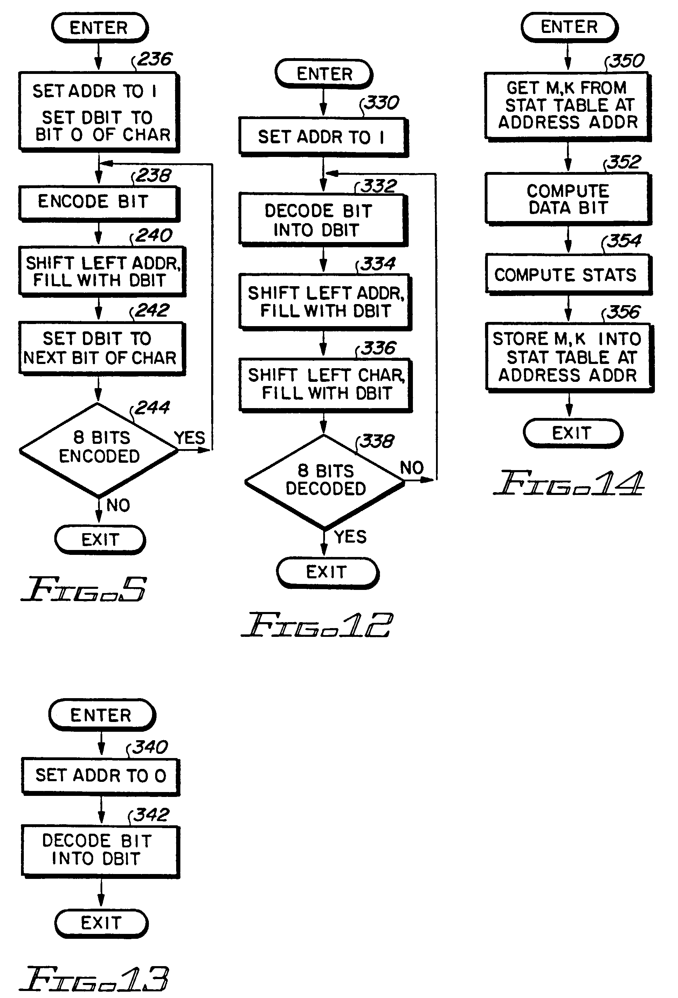

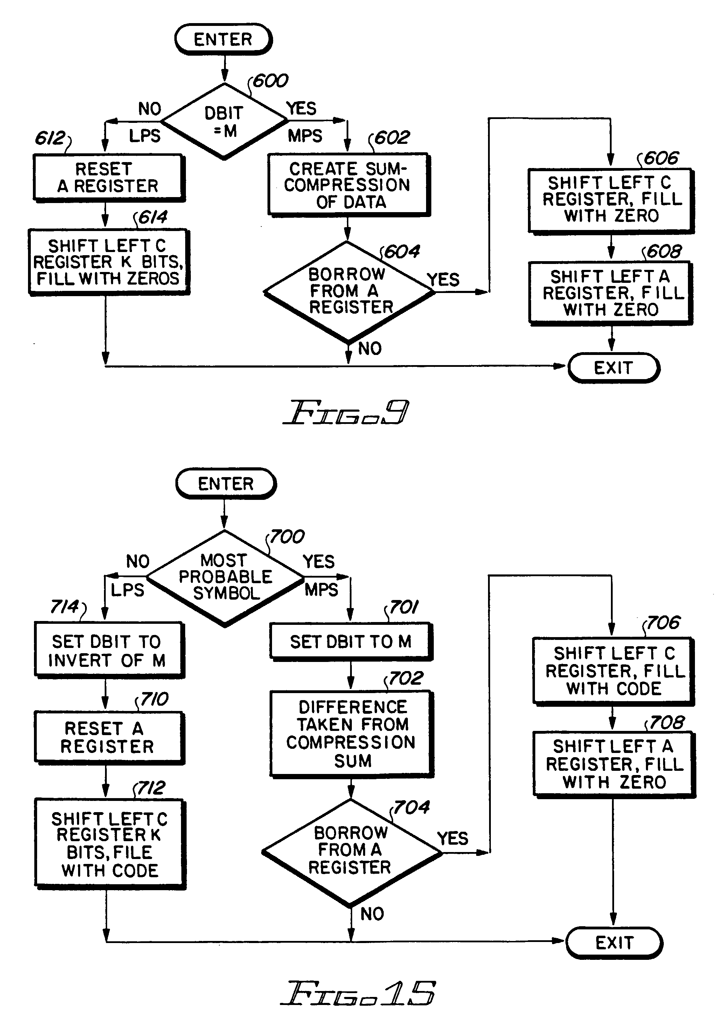

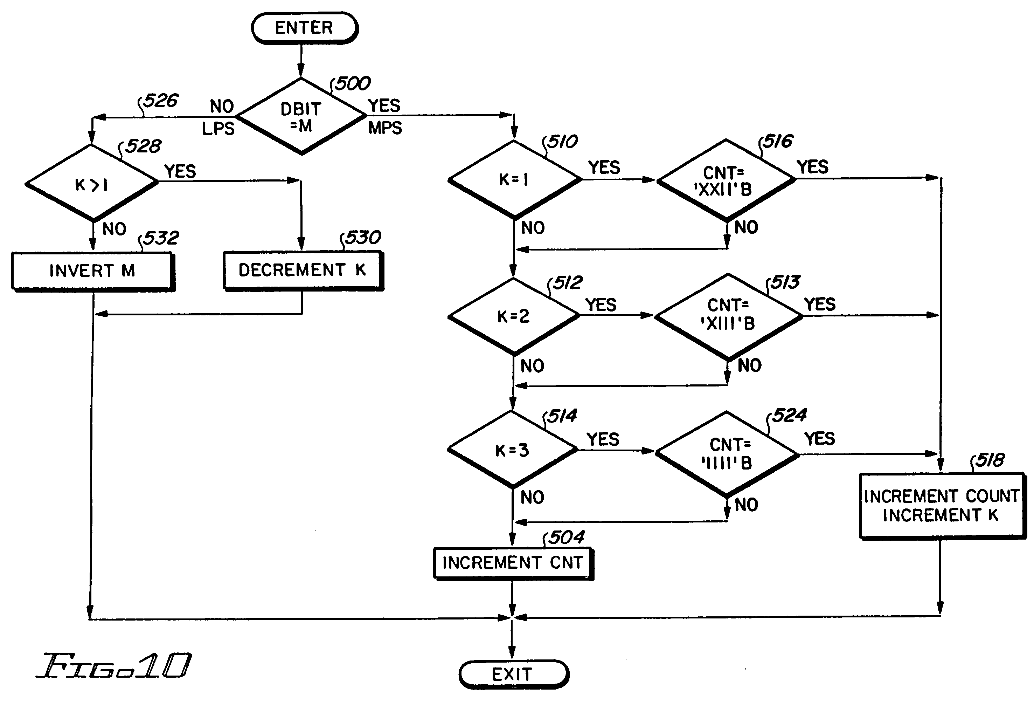

The flow chart of Figure 4 shows the overall encode process for a set of data. As stated, the set of data is 512 bytes except for the last set which is the remainder bytes left over after the separation of the stream of data into the sets of data. For each set of data, the encoder is initialised to a known state. The statistic tables are not initialised for each set of data, rather they are initialised only for each channel record. The RUNCHAR register is initialised. The RUNMODE register is reset at the beginning of each set of data. Each byte of the set is fetched and loaded in the CHAR register. If the RUN mode is set then the RUNCHAR and the CHAR registers are compared. If they are equal, then an encode repeat event, shown in Figure 6, is executed. Otherwise, an encode no-repeat event, shown in Figure 7, is executed and the encode CHAR process, shown in Figure 5, is executed. If the RUN mode was not set, then the encode CHAR process is entered directly.

Now that a byte of the set has been encoded in the RUN mode, the RUN mode determination has been made. The RUNCHAR and CHAR register are compared. If they are equal, the RUN mode is set. Otherwise, the RUN mode is reset and the RUNCHAR register is set to the CHAR register information for the next RUN mode event.

The process is repeated until all bytes of the set of data are processed. The encode no-repeat event is executed to end the set of data processing in the run mode. Whether RUN mode is set or reset, the contents of the code register in the encoder are shifted out as part of the code.

The flow diagram of Figure 4 starts in block 200, by initialising or resetting the different registers to start the operation. The next step, in block 204, is to get the next byte from the set of data and place it into the CHAR register. The decision block 206, is whether the run mode sequence has been set. If not, a "no" line 208, is taken to the next step in block 210, where this byte is encoded. The process continues in a block 212 to check whether the character is the same as the previous character. If not, the NO line is taken to reset the run mode in a block 214 and to set the RUNCHAR register equal to the CHAR register, also shown in block 214. The process continues to get the next byte, block 204. If the run mode, block 206, has been set, the YES line is taken to go to the next decision block 220 to check to see whether the information in the RUNCHAR register is the same as the CHAR register. If it is, a yes line 222 is taken to encode the repeated event in a block 224, and to proceed again down the process chart where the character is checked to see if it is equal to the last character, block 212, and, since it is, the run mode is continued to be set in block 218, and to return to the beginning of the sequence to get more data. The RUN mode sequence is used if the previous bytes are the same and the encode unit compacts this similar data according to the binary arithmetic coding process. If the character of this byte is not the same and therefore the NO line is taken from block 220, the no-repeat event is encoded in a block 226, and the flow continues to encode the character in block 210. Since the RUNCHAR register is not equal to the CHAR register, the NO decision line from block 212 is taken to reset the run mode in block 214. The process then continues in the same mode to check each byte since the RUN mode character is not set and at this time it is the bit mode where the bits of each of the byte are processed to compact the non-similar bits of this byte. The process continues to check for all of the bytes in the set of data to be encoded. The decode process to decode the information just encoded is shown in Figure 11. The process flow for some of the separate blocks of Figure 4 is shown is Figures 5-8.

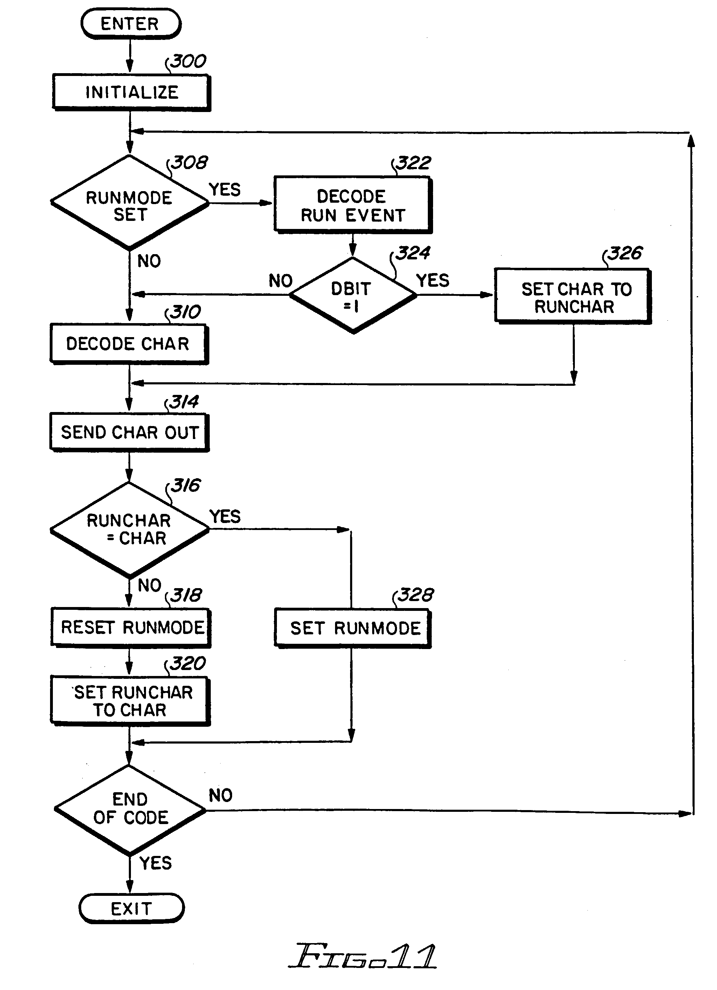

Figure 5 shows the ENCODE CHAR procedure of block 210 of Figure 4. When the bytes are not repeated, in the non-run mode, each byte is encoded by the encode character of block 210, shown in Figure 4. For each of the eight bits of the byte stored in the character CHAR buffer, statistics are fetched, then encoded by the encode procedure shown in Figure 8. The updated statistics are then stored back into statistics table. To encode a byte, a DBIT register is set first to the most significant bit of the byte. The address at which the statistics are fetched for the first bit, ADDR, is set to 1, as shown in block 236. The bit is encoded, block 238, using the ADDR address and the encode bit process shown in Figure 8. For encoding the next most significant bit, the new statistics table address is generated by shifting the ADDR address, as shown in block 240, left one bit and filling with the DBIT. As shown in block 242, the DBIT is set to the next most significant bit of the CHAR register. The above process is repeated eight times, as shown in block 244, to encode all of the bits of the character.

The encode repeat event of block 224, of Figure 4, is shown in Figure 6. Address zero of the statistic tables is used for the run mode. The address ADDR is set to zero and the DBIT character is set to one, as shown in block 246, to indicate that a repeated bit is to be encoded, when the run mode is set. The encode bit process of Figure 8 is then execute to encode the repeat event, as shown in block 248.

The encode non-repeat event of block 226, of Figure 4, is shown in Figure 7. The first step is shown in block 250, to set the address ADDR of the statistic tables to zero and to set the DBIT character to zero, to indicate that a bit that is not equal to the run character is to be encoded when the run mode is set. Address zero of the statistic tables is used for the run mode. Then the encode bit process of Figure 8 is executed, as shown in block 252, to show that a break in the run mode has happened and that the non-run character is encoded in the encode character block 210, as shown in Figure 4.

The encode bit process of Figure 8 is used in the block 238 of Figure 5, the encode bit block 248 of Figure 6 and the encode bit block 252 of Figure 7. In the first step of the process, block 254, the statistics M and K are fetched from the statistic tables at the address specified by the address ADDR. The M statistics is a one bit value indicating the guessed value and the statistic K is a two bit probability value. K can be a number from one to four. M, K, and DBIT are used to encode the bit using the process in the compute code block 256. The compute code process is shown in Figure 9. Next as shown in block 258, the statistics are updated to adapt to the data. This is done in the compute STATS process shown in Figure 10. After the new statistics are computed in M and K, the statistics values are stored into the statistic tables at the address specified by the address ADDR, as shown in block 260.

As shown in Figure 9 for the compute code process, the encoding process generates a sum of the probability. The sum is the code, which is the output of the encoder. The sum is generated by adding and shifting operations on a sum register C. Also, a normalisation register is used, register A. In the preferred embodiment, both the A and C registers have four bits each. In the initialisation step of Figure 4, both A and C registers are initialised to zero. The first step in the compute code process of Figure 9 determines whether a most probable symbol MPS, or a least probable symbol LPS, is to be encoded, as shown in block 600. If the DBIT is equal to the guessed value M, then an MPS is to be encoded. Otherwise, an LPS is to be encoded and the SPS, line 526, is taken. The A register is reset to zero and the C register is shifted left K time. The C register is filled with zeros when shifted left X times. The bits coming out of the C register by the shift process, are concatenated into a string of bits. The compacted data is this string of bits coming out of the C register, with additional operations performed on this string.

For a most probable symbol (MPS) a probability factor is generated from K, denoted by PF. The PF is four bit value that is used to perform arithmetic operations on the A and C registers. If K is 1, then PF is set to 1000. If K is 2, then PF is set to 0100. If K is equal to 3, then PF is set to 0010. If K is equal to 4, the table in PF is set to 0001. The PF value is added to the contents of the C register. If there is a carry out of the C register, then the carry out is propagated through the previous code bits that were generated. The new four bit sum is stored back in the C register. Further, the PF is subtracted from the contents of the A register and the new difference is stored back in the A register. If there was a borrow into the A register on the subtraction process, both the A and the C registers are shifted left one bit each, and each are filled with a zero. The bit shifted out of the C register is concatenated with the previous code bit to form the compacted data.

Since the bits shifted out of the C register is a sum of the probabilities, the carry out of the C register has to be propagated for the entire sum. It is not practical to store the entire sum in the encoder, and so the carry out propagation has to controlled, such that the code already sent out of the encoder does not need to have the carry propagated through the output. This is accomplished by stuffing bits.

The sum coming out of the C register is concatenated into eight bit bytes and sent out of the encoder. Whenever a code bit with a value of all ones for the eight bits is detected, four bits of zeros are inserted after the all ones byte, to prevent a carry out of the C register from propagating to the all-ones byte. If there is a carry out of the C register, the stuffed four bits of zeros are incremented by one, thus preventing the carry out from propagating to the all ones code byte. One benefit of byte stuffing is that it allows for special character codes to be inserted in the code stream. Since an all-ones bit can be followed by only one of two combinations for the next four bits, namely 0000 and 0001, anything other than these two values can not have been generated by the encode process and so a two byte special character can be inserted. These special characters are the end of set delineators, separating the different compacted sets of data.

In Figure 10, and referring to United States Patent A- 4,463,342, the probability calculation based on the statistic table are compacted. A Monte Carlo counter, CNT, is used to determine what is done to the statistics tables M and K. The Monte Carlo technique is where the decision to preform or not perform a task is based on an answer determined from a pseudo random number, rather than a deterministic approach. The CNT counter is a four bit binary UP counter. The CNT counter is reset to zeros in the initialisation step of Figure 4. The first step, as shown in block 500 of Figure 10, is to determine if the most probable symbol MPS, or the least probable symbol LPS was processed. The MPS is when the DBIT and the M statistic are equal. The LPS is determined if they are not equal. If the LPS was processed, the guess was wrong, and the probability value of the guessed value occurring should be immediately reduced. If K is already 1, checked in block 528, then the statistics M is inverted, block 532, so that now the opposite value is saved for the guessed value. If an MPS as processed, the guess was correct and the probability value of this guessed value occurring should be increased, but not always, since increasing always leads to the maximum value of K too quickly and the penalty for guessing wrong would be much higher. Therefore, the Monte Carlo counter is used to increment K randomly. If K is equal is 1, decision block 510, and the two low ordered bits of the CNT counter are ones, block 516, then K is incremented block 518. If the K statistics value is 2 and the three low ordered bits of the counter CNT are ones block 513, then K is incremented block 518. If the statistics K is 3, block 514, and all four bits of the CNT counter are one, block 524, then the value K is incremented. If K is equal to four, then it has already at its maximum and stays there. Regardless of the value of K, for an MPS, the CNT counter is incremented, blocks 504 and 518.

Figures 11 through 15 describe the flow of processing for the decode process. Figure 11 shows the flow chart for the overall decode process for a set of data sent to the channel adapters. A set of data is 512 bytes except for the last set or remainder for the preferred embodiment. For each set of data, the decoder 124 of Figure 3, for instance, is first initialised to a known state. Note that the statistics table is not initialised for each set of data, rather it is initialised only for each channel stream of record. The RUNCHAR register is initialised and the run MODE indication is reset at the beginning of each set of data. The C register of the decoder is loaded with the foremost significant bits of the first byte of the compacted data. The decode process decodes a bit at a time in the non-run mode. Eight bits are assembled in a byte and sent as a byte of channel data. For the run mode, the repeated byte is sent out as a byte of channel data, the process continues until all compacted data for that set of data is used and all of the bits of a set of data is decoded. If the run mode is set as shown in block 308, the YES line is taken to the decode run event of block 322. The decode run event, shown in Figure 13, is processed and a value returned in the DBIT register. If the DBIT is one, then a repeated bit was encoded in the run mode, so the RUNCHAR is copied to the CHAR register and sent out as shown in block 314. If the DBIT is zero, then the decode character block 310, shown in Figure 12, is processed to decode a byte of data into the CHAR register and then send the byte out. Then the run mode determination is made. If the RUNCHAR register is equal to the CHAR register, as shown block 316, the YES line is taken to set the run mode as shown in block 238. If the RUNCHAR is not equal to the CHAR, then the run mode is reset and the CHAR register is copied to the RUNCHAR register. The process continues until all the compacted data is used and all of the bytes of a set of channel data are decompacted.

The decode character process of block 310, shown in Figure 11, is shown in Figure 12. When the bytes are not repeated, for instance, the NO line was taken from block 308, showing that the run mode is not continued, see Figure 11, the address ADDR at which the statistics are fetched for the first bit, is set to one. In the non-run mode, each bit is decoded by the decode character process shown in Figure 12. For each of the eight bits of a byte to be decoded, the statistics are fetched, a bit is decoded by the decode process shown in Figure 14, and the updated statistics are stored back in the statistic tables. The address at which the statistic are fetched for the first bit, is set to one, as shown in block 330. The decode bit is placed into the DBIT register as shown in 332. The first bit decoded in the DBIT register is stored at the most significant bit of the CHAR register. For decoding the next bit, the new statistic table address is generated by shifting the address ADDR left one bit, while filling that bit with the DBIT, as shown in block 334. The next bit decoded is stored at the next most significant bit of the CHAR register. This is done by shifting the left character of the CHAR register and filling the register with the DBIT as shown in block 336. The above process is repeated eight times to decode all of the bits into the CHAR register, as shown in the decision block 338.

The decode run event of block 322, in Figure 11, is shown in Figure 13. Address zero of the statistic table is used for the run mode, therefore, the address ADDR is set to zero, as shown in block 340 of Figure 13. The decoded bit is then placed into the DBIT register and the decode bit is executed to decode the run event as shown in block 342.

The decode bit process of block 332, of Figure 12, is shown in Figure 14. The statistics M and K are fetched from the statistic tables at the address specified by the ADDR signal as shown in block 350. The statistics M is a one bit value indicating the guess value and the statistics K is a two bit probability value. The statistics K can be a number from one to four. The statistics M and K are used to decode a bit using the process in the compute data bit shown in Figure 15. In the compute data bit process of block 352, a bit is decoded and stored into the DBIT register. Then the statistics are updated as shown in block 354, to adapt the statistics to the data being decoded. This is done in the compute statistics process shown in Figure 10. After the new statistics are computed in the statistics M and K, the statistics M and K are stored back into the statistics tables at the address specified by the ADDR signal as shown in block 356.

Referring to Figure 15, the compute data bit process of block 352 in Figure 14 is shown. The decoding processes uses the same type of A and C registers as the encoding process. The A register is the normalisation register and is used the same way in the encoding process. The C register is the code register. In the preferred embodiment, both the A and the C registers have four bits each. In the initialisation step of Figure 8 for the decode cycle, both the A and the C registers are initialised to zero. The first four bits of the compacted data are then shifted into the C register. The first step shown in block 700 of Figure 15 for the computation of the data bit is to determine whether a most probable symbol (MPS) or a least probable symbol (DPS) was encoded. A trial subtraction is preformed on the C register to determine whether the MPS or the LPS was encoded. The probability factor PF is generated from the statistic K. The PF is a four bit value that is used to perform arithmetic operations on the A and C registers. The probability factor PF can be translated from the statistics K, in the same manner as for the compute code process for Figure 9. The PF is subtracted from the contents of the C register, and if a borrow into the C register is required, then an LPS must have been encoded, otherwise, an MPS was encoded. For an LPS from block 700, the A register is reset to zeros as shown in block 710, and C register is shifted left K times as shown in block 712. The bits coming out of the C register are discarded. The C register is filled with compacted data. Since it has been determined that an LPS has occurred, the process must have guessed wrong on the encode process, the DBIT is set to the invert value of M, as shown in block 714. For an MPS, the probability factor PF is subtracted from the contents of the C register, as shown in block 702. The new four bit difference in stored back into the C register. Also, the PF is subtracted from the contents of the A register and the new difference is stored back in the A register. If there was a borrow into the A register on the subtraction process, as shown in block 704, both the A and C registers are shifted left one bit each, as shown in blocks 706 and 708. The A register is filled with a zero and the C register is filled with a bit of the compacted data. The bit shifted out of the C register is discarded and, since an MPS has been determined, that is, the process must have guessed right on the encode process, the DBIT register is set to the value M as shown in block 701.

When the compacted data is shifted into the C register, the stuffed bits for preventing carry out must be removed, see the compute code process of Figure 6. The stuffed bits are identified by an all ones byte followed by the four most significant bits of the next code byte, being all zeros or 0001. If the four bits following the all ones byte are all zeros, then no action if taken and the four zero bits are simply discarded, i.e., not shifted into the C register. If the four bits following the all ones byte are 0001, then the contents of the C register are incremented by one and stored back into the C register. Also, the four bits 0001, are discarded, i.e. not shifted into the C register. If the four bits following the all ones byte are not all zeros and not 0001, then the all ones byte and the following byte are special characters inserted into the code stream. These special characters are the end of set characters or the end of record characters, delineated between the sets or identifying the end of the record. When the end of set or end of record characters are encountered in the code stream, the decoding process continues until all of the data bits are decoded and the C register contents are all zeros, since this was the starting condition on the encode process.

The decompaction or decoding sequence is the most time-critical for the channel speed. The bit of data at the I-TH level of the tree has to be decoded in order to calculate the tree address needed to decode the bit at the next highest tree level. For a simple overlap, where the statistics table access time is equal to the decoded cycle time, two adjacent statistic locations are fetched, one for each possible result of the I-TH level bit of data. When the lower order address bit becomes known, such lower order bits become control signals which select and route the required statistics to the compaction unit. Simultaneously, the statistics adaptive process operates on the statistics and replaces it on the appropriate data register. The data register is then rewritten to the statistics table. The requirement for the two independent data register memory units can be solved by using a dual port memory. A dual port memory simultaneously reads and writes to two different memory address. When reading at one tree level and writing to another tree level, the addresses of the levels are guaranteed to be different. Therefore, the statistics table is never updated while it is being read.

For a more complete description of the process flow used in the compaction unit being described, reference can be made to United States Patent A-4,286,256, United States Patent A-4,463,342 and United States Patent A-4,467,317. All of these patents are assigned to the assignee of the present invention. The compaction unit according to the present invention is a modified version shown in these three patents. The modification mainly is that two statistical tables are included for each encode and decode section and the duplication of the statistic tables permits the use of common hardware, that is, one encoder or decoder, while permitting a format compatible to a system with twice the throughput data rate. Less hardware means less cost.

The encode process of Figure 4, is perhaps best understood by referring to the aforementioned United States Patent A-4,467,317. As used in the patent, the first register is register C, while the second register is register A. In the preferred embodiment, each of the registers A and C has 4 bits. Each are programmed to act as shift registers. Register C, during the encode cycle, contains the compressed data while during decode it contains the uncompressed data.

Referring to Figure 15, the decode process is very similar to the encode process except that when the most probable symbol (MPS) is indicated in block 700, a difference is taken from the sum calculated during compression in block 702, to generate the uncompressed data. The A register control is identical as the encode cycle. The generation of a borrow in the A register causes normalisation, while the lack of a borrow causes no control action to be taken. For the LPS decision from the first decision block 700, the A register is reset in block and the C register is left shifted by K bits and filled with the compressed data to be decoded rather than the zeros during the encode cycle.

## Claims

1. A data compaction system (16) comprising a plurality N of compaction processors (17), each compaction processor having one encoder (114) and one decoder (124), and each of the encoders and decoders having a plurality M of statistic tables (113, 115, 123, 125), wherein the system is configurable to use a number n of the compaction processors less than the possible maximum N and a number m of the statistic tables per encoder and decoder less than the possible maximum M, wherein each compaction processor handles an equal sized set of data for coding, and wherein if q=number of sets of data to be coded and i=set number of q, set i is processed by compaction processor j using the statistical table k, where j=i modulo n and k=(i/n) modulo m.

## Patentansprüche

1. Datenkomprimierungssystem (16), das eine Vielzahl N von Komprimierungsprozessoren (17) enthält, wobei jeder Komprimierungsprozessor einen Codierer (114) und einen Decodierer (124) hat und jeder der Codierer und Decodierer eine Vielzahl M von Statistiktabellen (113, 115, 123, 125) hat, wobei das System so konfiguriert werden kann, daß es eine Anzahl n der Komprimierungsprozessoren, die kleiner als die mögliche Höchstzahl N ist, und eine Anzahl m der Statistiktabellen pro Codierer und Decodierer, die kleiner als die mögliche Höchstzahl M ist, verwendet, wobei jeder Komprimierungsprozessor einen gleich großen Datenblock zur Codierung verarbeitet und wobei, wenn q = die Anzahl von zu codierenden Datenblöcke und i = die Datenblocknummer von q ist, der Datenblock i vom Komprimierungsprozessor j unter Verwendung der Statistiktabelle k verarbeitet wird, wobei j = i Modulo n und k = (i/n) Modulo m.

**Revendications**

1. Système de compression de données (16) comprenant une pluralité N de processeurs de compression (17), chaque processeur de compression comportant un codeur (114) et un décodeur (124), et chacun des codeurs et des décodeurs comportant une pluralité M de tables statistiques (113, 115, 123, 125), dans lequel le système peut être configuré pour utiliser un certain nombre n des processeurs de compression, inférieur au maximum possible N et un certain nombre m des tables statistiques par codeur et décodeur, inférieur au maximum possible M, dans lequel chaque processeur de compression manipule un ensemble de données de taille égale pour le codage, et dans lequel si q = nombre des ensembles de données à coder et i = numéro d'ensemble de q, l'ensemble i est traité par le processeur de compression j en utilisant la table statistique k, avec j = i modulo n et k = (i/n) modulo m.

FIG.1

FIG.6

FIG.7

FIG.8

TO A-BUS

CP1 *17* CP2

A-
MOUT | I/O CONTROL A-1 | A-
MOUT | I/O CONTROL A-2 | A-
MOUT

*25* *27* *29*

ROTARY
DMX/MX A-1 | ROTARY
DMX/MX A-2

*27* *27*

*36* *38*

FROM
CP4 | ENCODE
1 | DECODE
1 | ENCODE
2 | DECODE
2 | TO
CP3

*37* *39*

ROTARY
MX/DMX B-1 | ROTARY
MX/DMX B-2

*39* *39*

B-
MOUT | *43*
I/O CONTROL B-1 | B-
MOUT | I/O CONTROL B-2 | B-
MOUT

TO UTILIZATION DEVICE

*Fig.2*

A-MOUT
FROM CP4

*134*
INTERFACE
CONTROL –A

A-
MOUT
TO CP2

↑TO A-BUS

*136*
STORAGE
DEVICE –A

*132*
EVENT
COUNTER–A

*141*

*114*
ENCODER

*124*
DECODER

*113*
STAT
TABLE E1

*115*
STAT
TABLE E2

*123*
STAT
TABLE D1

*125*
STAT
TABLE D2

*144*
SPEED
MATCHING
BUFFER

*138*
EVENT
COUNTER-B

*140*
STORAGE
DEVICE-B

B-BUS

B-
MOUT
FROM
CP4

*142*
INTERFACE
CONTROL
-B

B-MOUT
TO CP2

CODE:

*146*
———→ CONTROL LINES

*148*
═══⟩ WDF

*150*
╌╌⟩ RDF

𝓕𝓘𝓖.3

ENTER

INITIALIZE ⌐*200*

GET NEXT BYTE
OF DATA INTO CHAR ⌐*204*

RUNMODE
SET ⌐*206* — YES → RUNCHAR
=CHAR ⌐*220* — YES → ⌐*222*

NO ↓ *208*

RUNCHAR
=CHAR → NO ⌐*226* → ENCODE
NO-REPEAT EVENT

ENCODE
REPEAT EVENT ⌐*224*

ENCODE CHAR ⌐*210*

RUNCHAR
=CHAR ⌐*212* — YES → SET RUNMODE ⌐*218*

NO ↓ ⌐*214*

RESET RUNMODE
SET RUNCHAR TO
CHAR

MORE
DATA — YES →

NO ↓

RUNMODE
SET ⌐*230* — NO → CLEAR ENCODER ⌐*232* → EXIT

YES ↓

ENCODE
NO-REPEAT EVENT ⌐*234*

FIG.4

## FIG. 5

```
        ( ENTER )
            │
            ▼          ⌐236
    ┌─────────────────┐
    │  SET ADDR TO I  │
    │   SET DBIT TO   │
    │  BIT O OF CHAR  │
    └─────────────────┘
            │
            ▼          ⌐238
    ┌─────────────────┐
    │   ENCODE BIT    │◄──────┐
    └─────────────────┘       │
            │          ⌐240   │
            ▼                  │
    ┌─────────────────┐       │
    │ SHIFT LEFT ADDR,│       │
    │  FILL WITH DBIT │       │
    └─────────────────┘       │
            │          ⌐242   │
            ▼                  │
    ┌─────────────────┐       │
    │   SET DBIT TO   │       │
    │ NEXT BIT OF CHAR│       │
    └─────────────────┘       │
            │          ⌐244   │
            ▼                  │
         ╱────────╲  YES       │
        ╱  8 BITS  ╲───────────┘
        ╲ ENCODED  ╱
         ╲────────╱
            │ NO
            ▼
        ( EXIT )
```

**FIG. 5**

## FIG. 12

```
        ( ENTER )
            │
            ▼          ⌐330
    ┌─────────────────┐
    │  SET ADDR TO I  │
    └─────────────────┘
            │
            ▼          ⌐332
    ┌─────────────────┐
    │   DECODE BIT    │◄──────┐
    │    INTO DBIT    │       │
    └─────────────────┘       │
            │          ⌐334   │
            ▼                  │
    ┌─────────────────┐       │
    │ SHIFT LEFT ADDR,│       │
    │  FILL WITH DBIT │       │
    └─────────────────┘       │
            │          ⌐336   │
            ▼                  │
    ┌─────────────────┐       │
    │ SHIFT LEFT CHAR,│       │
    │  FILL WITH DBIT │       │
    └─────────────────┘       │
            │          ⌐338   │
            ▼          NO      │
         ╱────────╲───────────┘
        ╱  8 BITS  ╲
        ╲ DECODED  ╱
         ╲────────╱
            │ YES
            ▼
        ( EXIT )
```

**FIG. 12**

## FIG. 14

```
        ( ENTER )
            │
            ▼          ⌐350
    ┌─────────────────┐
    │   GET M,K FROM  │
    │   STAT TABLE AT │
    │  ADDRESS ADDR   │
    └─────────────────┘
            │
            ▼          ⌐352
    ┌─────────────────┐
    │    COMPUTE      │
    │    DATA BIT     │
    └─────────────────┘
            │
            ▼          ⌐354
    ┌─────────────────┐
    │  COMPUTE STATS  │
    └─────────────────┘
            │
            ▼          ⌐356
    ┌─────────────────┐
    │  STORE M,K INTO │
    │   STAT TABLE AT │
    │  ADDRESS ADDR   │
    └─────────────────┘
            │
            ▼
        ( EXIT )
```

**FIG. 14**

## FIG. 13

```
        ( ENTER )
            │
            ▼          ⌐340
    ┌─────────────────┐
    │  SET ADDR TO O  │
    └─────────────────┘
            │
            ▼          ⌐342
    ┌─────────────────┐
    │   DECODE BIT    │
    │    INTO DBIT    │
    └─────────────────┘
            │
            ▼
        ( EXIT )
```

**FIG. 13**

ENTER

*600*

NO    DBIT    YES
LPS    =M    MPS

*612*
RESET
A REGISTER

*602*
CREATE SUM-
COMPRESSION
OF DATA

*606*
SHIFT LEFT C
REGISTER, FILL
WITH ZERO

*614*
SHIFT LEFT C
REGISTER K BITS,
FILL WITH ZEROS

*604*
BORROW
FROM A    YES
REGISTER

NO

*608*
SHIFT LEFT A
REGISTER, FILL
WITH ZERO

EXIT

*Fig. 9*

ENTER

*700*

NO    MOST    YES
LPS   PROBABLE   MPS
SYMBOL

*714*
SET DBIT TO
INVERT OF M

*701*
SET DBIT TO M

*706*
SHIFT LEFT C
REGISTER, FILL
WITH CODE

*710*
RESET A
REGISTER

*702*
DIFFERENCE
TAKEN FROM
COMPRESSION
SUM

*708*
SHIFT LEFT A
REGISTER, FILL
WITH ZERO

*712*
SHIFT LEFT C
REGISTER K
BITS, FILE
WITH CODE

*704*
BORROW
FROM A    YES
REGISTER

NO

EXIT

*Fig. 15*

18

FIG.10

EP 0 429 306 B1

ENTER

INITIALIZE (300)

RUNMODE SET (308)
→ YES → DECODE RUN EVENT (322)
→ DBIT =1 (324)
NO / YES
YES → SET CHAR TO RUNCHAR (326)

NO →

DECODE CHAR (310)

SEND CHAR OUT (314)

RUNCHAR = CHAR (316)
YES →
NO → RESET RUNMODE (318)

SET RUNMODE (328)

SET RUNCHAR TO CHAR (320)

END OF CODE
NO →
YES → EXIT

*FIG.11*